# EUROPÄISCHE PATENTANMELDUNG

(11) **EP 4 517 684 A1**
(43) Veröffentlichungstag der Anmeldung: **05.03.2025**
(21) Anmeldenummer: 24193983.4
(22) Anmeldetag: 09.08.2024
(51) Int. Cl.: G06V 10/70, G06T 11/00, G06T 17/00, G06V 10/774

(54) **TRAININGSDATEN FÜR DIE ERKENNUNG EINES INHALTS EINES KÜHLGERÄTS**

(30) Priorität: 28.08.2023 DE 102023208178
(71) Anmelder: BSH Hausgeräte GmbH, 81739 München (DE)
(72) Erfinder: Perwass, Christian, 24214 Gettorf (DE)

(57) **Zusammenfassung**

Ein Verfahren (200) zum Bereitstellen von Trainingsdaten für ein System zur Erkennung eines Gegenstands (120) in einem Kühlgerät (110) umfasst Schritte des Erstellens (215) von Modellen (320) mehrerer Gegenstände (120); des Anordnens (220) der Modelle (320) in einem virtuellen Gefäß (325) mit einer Grundfläche (330), die größer als eine Grundfläche (335) des Kühlgeräts (110) ist; des Verkleinerns (225) der Grundfläche (330) des Gefäßes (325) und des Simulierens (235) einer Bewegung der Modelle (320) aufgrund der Verkleinerung; sowie des Bereitstellens (245) eines Bilds der in dem Gefäß (325) angeordneten Modelle (320).

## Beschreibung

Die vorliegende Erfindung betrifft ein Erkennungssystem für einen Inhalt eines Kühlgeräts. Insbesondere betrifft die Erfindung die Bereitstellung von Trainingsdaten für ein solches Erkennungssystem.

Ein Kühlgerät umfasst eine Kamera zur Erfassung eines Inhalts. Ein Bild des Inhalts kann verarbeitet werden, um Gegenstände zu erkennen, die sich im Kühlgerät befinden. Auf der Basis erkannter Gegenstände kann eine Inventarliste erstellt werden oder ein zur Neige gehender Vorrat eines bestimmten Artikels kann automatisch nachbestellt werden.

US 2020/033052 A1 schlägt ein Kühlgerät mit einer Innenraumkamera vor. Auf einem Bild eines Innenraums des Kühlgeräts kann mittels eines entsprechend trainierten künstlichen neuronalen Netzwerks ein vorbestimmter Gegenstand erkannt werden.

Zur Erkennung kann ein Gegenstand auf dem Bild freigestellt werden und die Erkennung kann mittels eines künstlichen neuronalen Netzwerks (KNN) erfolgen. Um das Netzwerk zum Erkennen zu trainieren, können 3D-Daten von Gegenständen verwendet werden, die beispielsweise von einem Hersteller oder Händler bereitgestellt sind. Sowohl zum Trainieren des Freistellens als auch des Erkennens des Gegenstands, ist es hilfreich, realistische Bilder des Innenraums zu verwenden, die jeweils eine Anordnung mehrerer Gegenstände zeigen. Für ein überwachtes Lernen sind beschriftete Datensätze (labeled data) erforderlich.

Eine der vorliegenden Erfindung zu Grunde liegende Aufgabe besteht in der Bereitstellung realistischer Bilder zum Trainieren eines Erkennungssystems für einen Inhalt eines Kühlgeräts. Die Erfindung löst diese Aufgabe mittels der Gegenstände der unabhängigen Ansprüche. Unteransprüche geben bevorzugte Ausführungsformen wieder.

Ein Verfahren zum Bereitstellen von Trainingsdaten für ein System zur Erkennung eines Gegenstands in einem Kühlgerät umfasst Schritte des Erstellens von Modellen mehrerer Gegenstände; des Anordnens der Modelle in einem virtuellen Gefäß mit einer Grundfläche, die größer als eine Grundfläche des Kühlgeräts ist; des Verkleinerns der Grundfläche des Gefäßes und des Simulierens einer Bewegung der Modelle aufgrund der Verkleinerung; sowie des Bereitstellens eines Bilds der in dem Gefäß angeordneten Modelle.

Das vorgeschlagene Verfahren kann dazu eingesetzt werden, realistische Bilder zu generieren, die einen Innenraum eines Kühlgeräts mit darin angeordneten Gegenständen zeigen. Die Bilder können automatisch generiert werden und für das Trainieren einer Erkennungseinrichtung verwendet werden, die maschinelles Lernen umsetzt. Die Erkennungseinrichtung kann insbesondere durch ein künstliches neuronales Netzwerk (KNN) gebildet sein. Mittels des Verfahrens können praktisch beliebig viele Ansichten generiert werden, die zum Trainieren des KNN geeignet sind.

Es wurde erkannt, dass durch das horizontale Zusammenschieben der Gegenstände eine Anordnung erzielt werden kann, die einer realen Anordnung in einem realen Kühlgerät verbessert ähnelt. Die Gegenstände können einander verschieben und teilweise verdecken, ein Gegenstand kann umkippen oder durch die Verkleinerung verformt werden. Eine solche horizontale Kompression des Inhalts des Gefäßes kann in verbesserter Weise einer Kompression entsprechen, die an einem realen Kühlgerät erfolgt, wenn Gegenstände ausschließlich in horizontaler Richtung eingelegt bzw. eingeschoben werden.

Dem Bild kann eine Information eines abgebildeten Gegenstands zugeordnet werden. Das Bild kann somit ein beschrifteter (labeled) Datensatz werden, der verbessert für ein überwachtes Lernen, beispielsweise an einem KNN, eingesetzt werden kann. Die Information kann beispielsweise eine Bezeichnung, eine eindeutige Identifikation oder eine Eigenschaft umfassen. Die Information kann Teil von Daten sein, die für das Erstellen des Modells eines abgebildeten Gegenstands verwendet werden. Solche Daten können insbesondere von einem Hersteller oder einem Händler des Gegenstands bereitgestellt sein.

Einem Modell kann eine physikalische Eigenschaft des modellierten Gegenstands zugeordnet sein. Die Bewegung eines Modells kann bezüglich der physikalischen Eigenschaft bestimmt werden. Eine Simulationsumgebung, die eine Simulation unter Beachtung physikalischer Eigenschaften erlaubt, wird auch Physik-Engine (physics engine) genannt. Mittels einer solchen Umgebung kann die simulierte horizontale Verschiebung bzw. Kompression leicht nachvollzogen werden. Dabei können eine oder mehrere physikalische Eigenschaften des Gegenstands berücksichtigt werden.

Die Eigenschaft kann insbesondere eine Abmessung, eine Form, eine Masse, die Lage eines Schwerpunkts, eine Verformbarkeit oder die Beschaffenheit einer Oberfläche des Gegenstands umfassen. Andere oder weitere Eigenschaften können ebenfalls berücksichtigt werden. So kann beispielsweise modelliert werden, dass ein Gegenstand während der Verkleinerung des Gefäßes horizontal verschoben wird, umkippt oder einen anderen Gegenstand zur Seite drängt.

Es ist weiterhin bevorzugt, dass eine Interaktion zweier Modelle aufgrund ihrer relativen Bewegung simuliert wird. Eine solche Interaktion kann insbesondere ein Verdrängen, ein Verdecken oder ein Verformen umfassen. In Abhängigkeit von Formen und Größen der Gegenstände kann ein erstes Modell ein zweites beispielsweise verschieben, anheben, umkippen, darauf fallen oder verformen.

In Anlehnung an einen Innenraum eines Kühlgeräts ist das Gefäß bevorzugt im Wesentlichen quaderförmig. Die Grundfläche des Gefäßes wird bevorzugt derart verkleinert, dass sie der Grundfläche des Kühlgeräts entspricht. Ist ein konkretes Kühlgerät nicht bekannt, so kann ein generisches Kühlgerät angenommen werden. Die Grundfläche des komprimierten Gefäßes kann in Form und Größe der Grundfläche des Kühlgeräts entsprechen.

Allgemein umfasst ein Kühlgerät einen Kühlschrank oder einen Gefrierschrank mit einer seitlichen Öffnung, die bevorzugt als Tür ausgeführt ist. Weniger bevorzugt ist ein Kühlgerät, das von oben beladen wird, beispielsweise eine Kühltruhe oder eine Schublade in einem Kühlgerät.

Die Modelle können in demselben virtuellen Raum wie das Gefäß erzeugt werden. Weiter bevorzugt werden die Modelle in zufälliger bzw. pseudo-zufälliger Weise in dem virtuellen Gefäß angeordnet. Die vorgeschlagene Technik der Bilderstellung kann im virtuellen Raum beliebig oft wiederholt werden, wobei durch die jeweils zufällige Platzierung eine vorteilhafte Variation in den generierten Bildern erzielt werden kann.

Für verschiedene Bilder können insbesondere eine Anzahl, eine Auswahl, eine Art oder eine Anordnung der Gegenstände variiert werden. Die Variation kann innerhalb vorbestimmter Grenzen oder bezüglich vorbestimmter Parameter zufällig bzw. pseudo-zufällig erfolgen. Weiter bevorzugt werden die Bilder aus einer Perspektive bestimmt, die der Perspektive einer Kamera an einem realen Kühlgerät entspricht. Das reale Kühlgerät kann eine Kamera in einer Tür umfassen, die ein Bild des Innenraums anfertigen kann, wenn die Tür einen vorbestimmten Öffnungswinkel erreicht hat. Bevorzugt wird das Bild angefertigt, während die Tür in Bewegung ist. So können reproduzierbare Perspektiven erzielt werden, die einen vorbestimmten Abstand vom Innenraum haben, sodass sich geringere Verzerrungen und ein verbesserter Überblick ergeben können. Durch vorteilhaftes Wählen des Öffnungswinkels kann verhindert sein, dass ein Benutzer zwischen die Kamera und den Innenraum tritt, während das Bild angefertigt wird.

Das Gefäß kann mehrere vertikal versetzte Stellflächen aufweisen. Eine solche Stellfläche kann insbesondere als Glasboden oder als Gitterrost ausgebildet sein. Dabei können Modelle von Gegenständen auf mehreren Stellflächen angeordnet werden. Der Innenraum eines realen Kühlgeräts kann so weiter verbessert simuliert werden. Eine Stellfläche verläuft allgemein parallel zur Grundfläche und somit in horizontaler Richtung. Eine fertig komprimierte Stellfläche kann so groß wie die Grundfläche sein. Eine Stellfläche kann auch nur einen Teil der Grundfläche abdecken. In jedem Fall wird mit dem Verkleinern der Grundfläche eine Stellfläche so verkleinert, dass sie die Grundfläche des Gefäßes nicht überragt. Insbesondere bei einer Variante mit mehreren Stellflächen kann auch berücksichtigt werden, dass durch das Verkleinern der Grundfläche ein Modell von einer höheren auf eine niedrigere Stellfläche herunterfallen kann.

Zum Bereitstellen des Bildes nach dem Verkleinern der Grundfläche kann eine seitliche Begrenzung des Gefäßes transparent gemacht werden, um das Bild zu generieren. Alternativ kann die seitliche Begrenzung entfernt werden. Eine Bewegung eines Gegenstands aufgrund des Entfernens kann dabei simuliert werden.

Das Entfernen der seitlichen Begrenzung kann dem Öffnen einer Tür des realen Kühlgeräts entsprechen. Bei diesem Vorgang können sich gegeneinander verkeilte Gegenstände entspannen, und ein Gegenstand kann aus dem Gefäß herausgedrängt werden. Auch dieser Vorgang kann simuliert werden. Allgemein bevorzugt ist die Begrenzung einem Betrachter des Bilds bzw. einer angenommenen Perspektive einer Kamera, die das Bild aufnimmt, zugewandt.

Nach einem weiteren Aspekt der vorliegenden Erfindung umfasst eine Vorrichtung zur Bereitstellung von Trainingsdaten für ein System zur Erkennung eines Gegenstands in einem Kühlgerät: einen Datenspeicher mit Daten wenigstens eines Gegenstands; eine Ausgabevorrichtung für ein Bild; und eine Verarbeitungseinrichtung. Dabei ist die Verarbeitungseinrichtung dazu eingerichtet, Modelle mehrerer Gegenstände zu erstellen; die Modelle in einem virtuellen Gefäß mit einer Grundfläche, die größer als eine Grundfläche des Kühlgeräts ist, anzuordnen; die Grundfläche des Gefäßes zu verkleinern und eine Bewegung der Modelle aufgrund der Verkleinerung zu simulieren; und ein Bild der in dem Gefäß angeordneten Modelle bereitzustellen.

Die Verarbeitungseinrichtung kann dazu eingerichtet sein, ein hierin beschriebenes Verfahren teilweise oder vollständig auszuführen. Dazu kann die Verarbeitungseinrichtung elektronisch ausgeführt sein und beispielsweise einen programmierbaren Mikrocomputer oder Mikrocontroller umfassen. Das Verfahren kann in Form eines Computerprogrammprodukts mit Programmcodemitteln vorliegen. Das Computerprogrammprodukt kann auch auf einem computerlesbaren Datenträger abgespeichert sein. Merkmale oder Vorteile des Verfahrens können auf die Vorrichtung übertragen werden und umgekehrt.

Nach einem weiteren Aspekt der vorliegenden Erfindung sind Trainingsdaten für eine Erkennungseinrichtung zur Erkennung eines Gegenstands, der in einem Innenraum eines Kühlgeräts angeordnet ist, mittels eines hierin beschriebenen Verfahrens bereitgestellt. Die Trainingsdaten können eine Vielzahl Bilder eines seitlich geöffneten Kühlgeräts umfassen, in welchem jeweils Gegenstände angeordnet sind. Die Bilder können bezüglich Daten erstellt sein, welche ein Aussehen und/oder eine physikalische Eigenschaft eines Gegenstands reflektieren. Dabei kann eine Bibliothek vorbestimmter Gegenstände verwendet werden, die durch die Erkennungseinrichtung erkannt werden sollen. Die Gegenstände umfassen insbesondere Lebensmittel und können sowohl verpackte als auch unverpackte Lebensmittel betreffen.

Nach wieder einem weiteren Aspekt der vorliegenden Erfindung umfasst ein Kühlgerät eine Kamera zur Erstellung eines Bilds eines Innenraums des Kühlgeräts; und eine Erkennungseinrichtung, die darauf trainiert ist, einen im Innenraum angeordneten Gegenstand zu erkennen. Dabei ist die Erkennungseinrichtung auf der Basis von hierin beschriebenen Trainingsdaten trainiert.

Das Kühlgerät kann erkannte Gegenstände über eine Schnittstelle nach außen bereitstellen. Auf der Basis erkannter Gegenstände kann beispielsweise eine Inventarliste von Gegenständen in dem Kühlgerät bestimmt werden. Die Inventarliste kann beispielsweise dazu verwendet werden, einen vorbestimmten Bestand an Gegenständen in einem Haushalt einzuhalten oder zu prüfen, ob eine Speise nach Mengenangaben von Gegenständen in einem zugeordneten Kochrezept auf der Basis vorhandener Gegenstände zubereitet werden kann. Ein Gegenstand, der für die Zubereitung fehlt, kann angegeben werden.

Die Erfindung wird nun unter Bezug auf die beiliegenden Figuren genauer beschrieben, in denen:
- Figur 1: ein System;
- Figur 2: ein Ablaufdiagramm eines Verfahrens; und
- Figur 3: beispielhafte Ansichten von Modellen in einem Gefäß
darstellen.

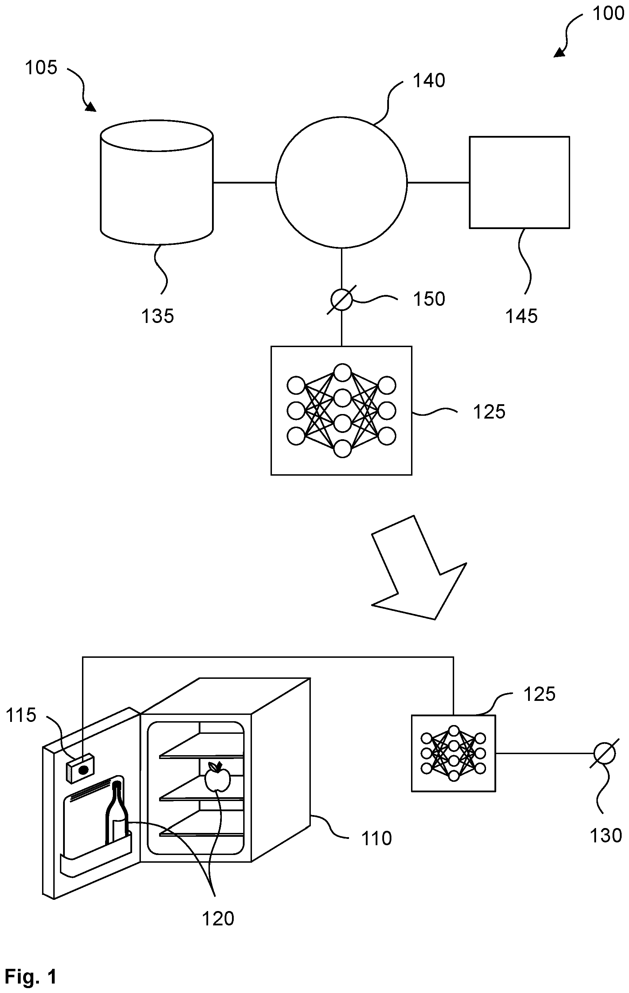

Figur 1 zeigt ein System 100, das eine Vorrichtung 105 und ein Kühlgerät 110 umfasst. Das Kühlgerät 110 umfasst eine Kamera 115, die dazu eingerichtet ist, ein Bild eines Innenraums anzufertigen, in welchem ein Gegenstand 120 angeordnet sein kann. Das Bild kann einer Erkennungseinrichtung 125 bereitgestellt werden, die darauf trainiert ist, einen abgebildeten Gegenstand 120 zu erkennen. Mittels einer Schnittstelle 130 kann ein Hinweis auf einen erkannten Gegenstand bereitgestellt werden.

Die Vorrichtung 105 ist dazu eingerichtet, Trainingsdaten für eine Erkennungseinrichtung 125 bereitzustellen. Die Vorrichtung 105 umfasst einen Datenspeicher 135, eine Verarbeitungseinrichtung 140, eine optionale Steuereinrichtung 145 und eine Schnittstelle 150.

Im Datenspeicher 135 sind Informationen über einen oder mehrere Gegenstände 120 abgelegt, die dazu verwendet werden können, jeweils ein dreidimensionales Modell eines Gegenstands 120 anzufertigen. Die Informationen können insbesondere eine Größe, eine Form oder eine optische Gestaltung umfassen. Weitere Informationen können beispielsweise physikalischer Natur sein. Außerdem kann einem Gegenstand 120 eine Bezeichnung, ein Name oder eine eindeutige Identifikation zugeordnet sein.

Die Verarbeitungseinrichtung 140 ist dazu eingerichtet, Modelle mehrerer Gegenstände 120 zu erzeugen und in einem virtuellen Gefäß anzuordnen. Das virtuelle Gefäß kann dann in vorbestimmter Weise verkleinert werden, sodass Gegenstände 120 im Innenraum des virtuellen Gefäßes verschoben oder komprimiert werden können. Die Verarbeitungseinrichtung 140 ist dazu eingerichtet, diesen Vorgang auf der Basis physikalischer Zusammenhänge zu simulieren. Ferner kann die Verarbeitungseinrichtung 140 ein Bild generieren, das eine Ansicht aus einer vorbestimmten Perspektive auf die Gegenstände 120 in dem virtuellen Gefäß zeigt. Das Bild kann mittels der Schnittstelle 150 bereitgestellt werden. Eine Vielzahl Bilder kann in einem Datenspeicher abgelegt werden, der dann Trainingsdaten zum Trainieren einer Erkennungseinrichtung 125 enthält. Generierte Bilder können auch direkt zum Trainieren einer Erkennungseinrichtung 125 verwendet werden. Eine trainierte Erkennungseinrichtung 125 kann mit überschaubarem Aufwand in Form einer elektronischen Datei an ein Kühlgerät 110 hochgeladen werden. Die Erkennungseinrichtung 125 ist mit einer Technik maschinellen Lernens ausgestattet, und die Trainingsdaten können bevorzugt dazu verwendet werden, ein überwachtes Lernen durchzuführen. Dazu kann einem Bild eine Kennzeichnung (Label) zugeordnet sein, welche Identifikationen oder Informationen eines oder mehrerer Gegenstände 120 auf dem Bild bzw. in dem virtuellen Gefäß, von dem das Bild erstellt wurde, umfasst.

Die Steuereinrichtung 145 kann eine Benutzerschnittstelle umfassen und ist dazu eingerichtet, den Prozess der Erstellung eines oder mehrerer Bilder zu steuern. Insbesondere kann über die Steuereinrichtung 145 vorgegeben werden, in welcher Weise eine Auswahl möglicher Gegenstände aus dem Datenspeicher 135 erfolgt, wie ausgewählte Gegenstände initial in dem virtuellen Gefäß angeordnet werden und/oder in welcher Weise eine Kompression des virtuellen Gefäßes erfolgt. Es ist bevorzugt, dass die Steuereinrichtung 145 einen oder mehrere Parameter, die auf die Erzeugung eines Bilds einen Einfluss haben, innerhalb vorbestimmter Parameter zufällig bzw. pseudo-zufällig variieren kann. Außerdem kann über die Steuereinrichtung 145 eine Anzahl zu generierender Bilder gesteuert werden.

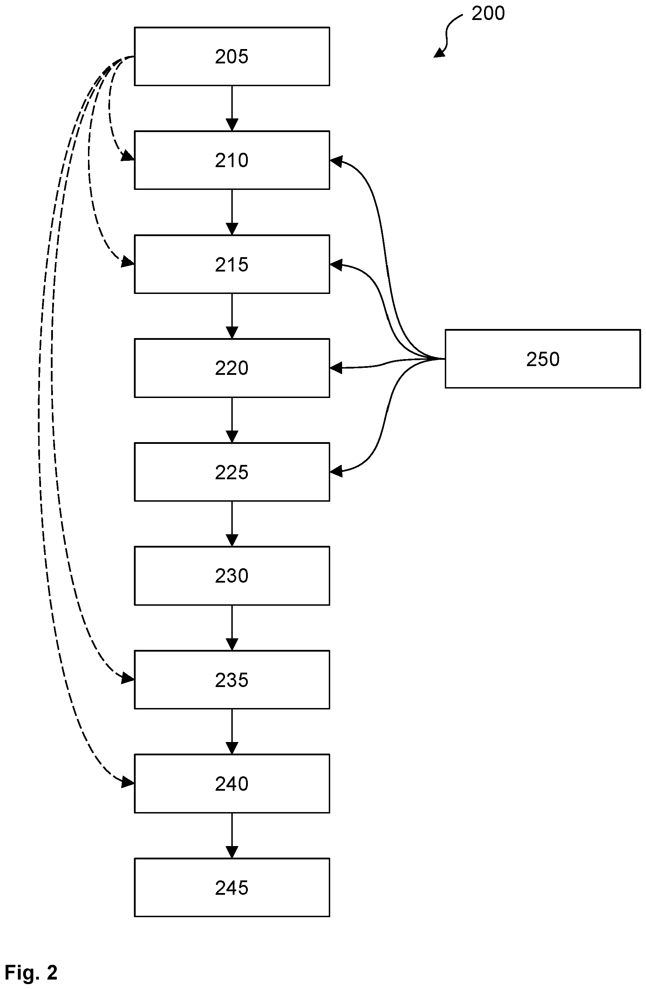

Figur 2 zeigt ein Ablaufdiagramm eines beispielhaften Verfahrens 200 zum Erzeugen von Trainingsdaten. Das Verfahren 200 kann insbesondere mittels einer Vorrichtung 105 durchgeführt werden. Trainingsdaten, die mittels des Verfahrens 200 bereitgestellt sind, können dazu verwendet werden, eine Erkennungseinrichtung 125 zu trainieren, die dann in einem Kühlgerät 110 eingesetzt werden kann.

In einem Schritt 205 können Daten eines Kühlgeräts von einem oder mehreren Gegenständen 120 erfasst werden. Daten bezüglich der Gegenstände 120 können insbesondere zur Erstellung eines Modells, zur Bestimmung einer zugeordneten Eigenschaft oder einer zugeordneten Information dienen. Daten des Kühlgeräts 110 können eine Form oder Abmessung eines Innenraums, die Größe und Form einer Grundfläche oder die Position der Kamera 115 betreffen. Die Kamera 115 kann an einer Tür des Kühlgeräts 110 angebracht und dazu eingerichtet sein, ein Bild des Innenraums anzufertigen, wenn die Tür um einen vorbestimmten Öffnungswinkel geöffnet ist. Die Kameraperspektive des Kühlgeräts 110 kann auf der Basis des Öffnungswinkels bestimmt sein.

In einem Schritt 210 kann ein virtuelles Gefäß erstellt werden. Das virtuelle Gefäß weist eine Grundfläche auf, die größer als die Grundfläche eines Innenraums des Kühlgeräts 110 ist. Das virtuelle Gefäß hat seitliche Begrenzungen, die Wänden oder der Tür des Kühlgeräts 110 entsprechen können. Umfasst das Kühlgerät 110 mehrere Stellflächen parallel zur Grundfläche, so kann auch das virtuelle Gefäß solche Stellflächen umfassen.

In einem Schritt 215 können Gegenstände 120 ausgewählt und Modelle der Gegenstände 120 erstellt werden. In einem Schritt 220 können die Modelle in dem virtuellen Gefäß angeordnet werden. Dabei werden die Modelle bevorzugt in zufälliger Weise auf der Grundfläche bzw. einer Stellfläche abgelegt. Dabei kann berücksichtigt werden, dass nicht jeder Gegenstand 120 aufgrund seiner Größe auf jeder Stellfläche in jeder Lage abgelegt werden kann. Unter Berücksichtigung solcher Restriktionen kann die Verteilung von Gegenständen 120 im virtuellen Gefäß im Wesentlichen zufällig sein.

In einem Schritt 225 kann das virtuelle Gefäß verkleinert werden, indem seine Grundfläche verkleinert wird. Am Ende des Verkleinerungsprozesses weist die Grundfläche des virtuellen Gefäßes bevorzugt dieselbe Form und Größe wie die Grundfläche des Innenraums des Kühlgeräts 110 auf. Während des Verkleinerns können die Modelle der Gegenstände 120 auf Grund der sich bewegenden horizontalen Begrenzungen des Gefäßes verschoben und gegeneinander gedrängt werden. Dieser Vorgang kann in einem Schritt 230 unter Berücksichtigung physikalischer Eigenschaften der Gegenstände 120 simuliert werden.

Ist die Verkleinerung abgeschlossen, so kann in einem Schritt 235 eine seitliche Begrenzung des Gefäßes entfernt werden. Die zusammengedrängten Modelle der Gegenstände 120 können sich dadurch möglicherweise entspannen und erneut bewegen. Gegebenenfalls kann ein Gegenstand 120 aus dem Gefäß herausfallen. In einer anderen Ausführungsform kann die Begrenzung nicht entfernt, sondern transparent gemacht werden.

In einem Schritt 240 können Daten bereitgestellt werden, die dem beschriebenen Vorgang zugeordnet sind. Die Daten können insbesondere Identifikationen der verwendeten Gegenstände 120 oder eine Angabe des Kühlgeräts 110 umfassen. In einem Schritt 245 kann ein Bild der Modelle der Gegenstände 120 im virtuellen Gefäß bereitgestellt werden. Die Daten können dem Bild zugeordnet werden, um zusammen Trainingsdaten (labeled data) zu bilden.

Mit unterbrochenen Linien sind in Figur 2 mögliche Einflüsse abgespeicherter Daten auf einzelne Verfahrensschritte dargestellt. Es ist bevorzugt, dass das Verfahren 200 mehrfach durchlaufen wird, um eine Vielzahl Bilder bzw. Trainingsdaten bereitzustellen. Zwischen den Durchläufen kann in einem Schritt 250 eine Variation bestimmter Parameter gesteuert werden. Insbesondere die Schritte 210 bis 225 können einer solchen Variation unterworfen werden. Parameter der Variation können systematisch, zufällig oder pseudo-zufällig variiert werden und eine Variation kann nach vorbestimmten Vorgaben automatisch erzeugt werden.

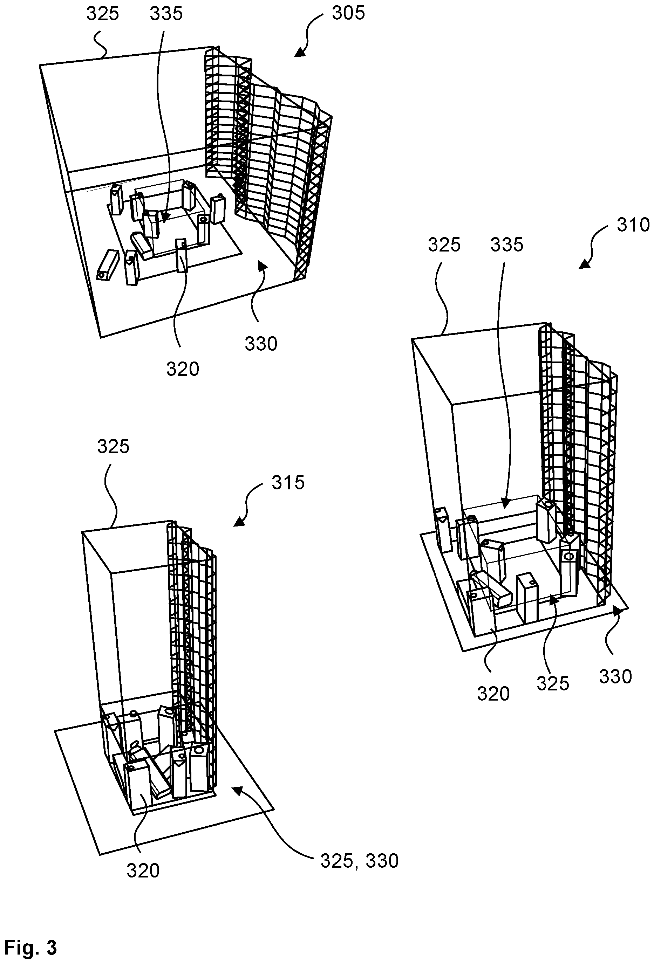

Figur 3 zeigt beispielhafte Ansichten 305, 310, 315 von Modellen 320 von Gegenständen 120 in einem Gefäß 325. Die Darstellungen entsprechen Visualisierungen in einem virtuellen Raum.

In der ersten Ansicht 305 sind mehrere Modelle 320 auf einer Grundfläche 330 des Gefä-ßes 325 verteilt. Ebenfalls eingezeichnet ist eine Grundfläche 335 eines vorbestimmten Kühlgeräts 110. Die Grundfläche 330 ist in zwei horizontalen Dimensionen größer als die Grundfläche 335 des Kühlgeräts 110. Modelle 320 einiger Gegenstände 120 liegen außerhalb der Grundfläche 335 des Kühlgeräts 110.

In der zweiten Ansicht 310 sind Begrenzungen des Gefäßes 325 nach innen gerückt, sodass die Grundfläche 330 des Gefäßes 325 verkleinert ist. Einige der Modelle 320 sind durch die Begrenzungen horizontal verschoben.

In der dritten Ansicht 315 ist die Grundfläche 330 des Gefäßes 325 so groß wie die Grundfläche 335 des Kühlgeräts 110. Die Modelle 320 sind gegeneinander geschoben, und einige Modelle 320 liegen teilweise übereinander. Eine solche Anordnung kann in realistischer Weise einer Anordnung von Gegenständen 120 im Innenraum eines realen Kühlgeräts 110 bei der Benutzung in einem Haushalt entsprechen. Die in Figur 3 auf der rechten Seite des Gefäßes 325 dargestellte, profilierte Begrenzung repräsentiert eine Tür des Kühlgeräts 110. Diese Begrenzung kann entfernt werden, und ein Bild der Modelle 320 im Innenraum des Gefäßes 325 kann aus einer vorbestimmten Perspektive angefertigt werden. Informationen über die modellierten Gegenstände 120 können dem erzeugten Bild beigefügt werden.

### Bezugszeichen

- 100: System
- 105: Vorrichtung
- 110: Kühlgerät
- 115: Kamera
- 120: Gegenstand
- 125: Erkennungseinrichtung
- 130: Schnittstelle
- 135: Datenspeicher
- 140: Verarbeitungseinrichtung
- 145: Steuereinrichtung
- 150: Schnittstelle
- 200: Verfahren
- 205: Daten eines Kühlgeräts und von Gegenständen erfassen
- 210: virtuelles Gefäß erstellen
- 215: Modelle von Gegenständen erstellen
- 220: Modelle im Gefäß anordnen
- 225: Gefäß verkleinern
- 230: Bewegung der Gegenstände simulieren
- 235: Begrenzung entfernen, Bewegung simulieren
- 240: Daten zuordnen
- 245: Bild bereitstellen
- 250: Variation
- 305: erste Ansicht
- 310: zweite Ansicht
- 315: dritte Ansicht
- 320: Modell
- 325: Gefäß
- 330: Grundfläche des Gefäßes
- 335: Grundfläche des Kühlgeräts

## Patentansprüche

1. Verfahren (200) zum Bereitstellen von Trainingsdaten für ein System zur Erkennung eines Gegenstands (120) in einem Kühlgerät (110), wobei das Verfahren (200) folgende Schritte umfasst:
- Erstellen (215) von Modellen (320) mehrerer Gegenstände (120);
- Anordnen (220) der Modelle (320) in einem virtuellen Gefäß (325) mit einer Grundfläche (330), die größer als eine Grundfläche (335) des Kühlgeräts (110) ist;
- Verkleinern (225) der Grundfläche (330) des Gefäßes (325) und Simulieren (230) einer Bewegung der Modelle (320) aufgrund der Verkleinerung; und
- Bereitstellen (245) eines Bilds der in dem Gefäß (325) angeordneten Modelle (320).

2. Verfahren (200) nach Anspruch 1, wobei dem Bild eine Information eines abgebildeten Gegenstands (120) zugeordnet (240) wird.

3. Verfahren (200) nach Anspruch 1 oder 2, wobei einem Modell (320) eine physikalische Eigenschaft des modellierten Gegenstands (120) zugeordnet ist; und wobei die Bewegung eines Modells (320) bezüglich der physikalischen Eigenschaft bestimmt (230) wird.

4. Verfahren (200) nach Anspruch 3, wobei die Eigenschaft eine Abmessung, eine Form, eine Masse, die Lage eines Schwerpunkts, eine Verformbarkeit oder die Beschaffenheit einer Oberfläche des Gegenstands (120) umfasst.

5. Verfahren (200) nach einem der vorangehenden Ansprüche, wobei eine Interaktion zweier Modelle (320) aufgrund ihrer relativen Bewegung simuliert wird.

6. Verfahren (200) nach einem der vorangehenden Ansprüche, wobei die Grundfläche (330) des Gefäßes (325) derart verkleinert wird, dass sie der Grundfläche (335) des Kühlgeräts (110) entspricht.

7. Verfahren (200) nach einem der vorangehenden Ansprüche, wobei die Modelle (320) in zufälliger Weise in dem virtuellen Gefäß (325) angeordnet (220) werden.

8. Verfahren (200) nach einem der vorangehenden Ansprüche, wobei für verschiedene Bilder eine Anzahl, eine Auswahl, eine Art oder eine Anordnung der Gegenstände (120) variiert (250) wird.

9. Verfahren (200) nach einem der vorangehenden Ansprüche, wobei das Gefäß (325) mehrere vertikal versetzte Stellflächen aufweist; wobei Modelle (320) auf mehreren Stellflächen angeordnet werden.

10. Verfahren (200) nach einem der vorangehenden Ansprüche, wobei nach dem Verkleinern (225) der Grundfläche (330) eine seitliche Begrenzung des Gefäßes (325) entfernt (235) wird; und eine Bewegung des Gegenstands (120) aufgrund des Entfernens simuliert wird.

11. Vorrichtung (105) zur Bereitstellung von Trainingsdaten für ein System zur Erkennung eines Gegenstands (120) in einem Kühlgerät (110), wobei die Vorrichtung (105) folgendes umfasst:
- einen Datenspeicher (135) mit Daten wenigstens eines Gegenstands (120);
- eine Ausgabevorrichtung (150) für ein Bild; und
- eine Verarbeitungseinrichtung (140), die dazu eingerichtet ist, Modelle (320) mehrerer Gegenstände (120) zu erstellen; die Modelle (320) in einem virtuellen Gefäß (325) mit einer Grundfläche (330), die größer als eine Grundfläche (335) des Kühlgeräts (110) ist, anzuordnen; die Grundfläche (330) des Gefäßes (325) zu verkleinern und eine Bewegung der Modelle (320) aufgrund der Verkleinerung zu simulieren; und ein Bild der in dem Gefäß (325) angeordneten Modelle (320) bereitzustellen.

12. Trainingsdaten für eine Erkennungseinrichtung zur Erkennung eines Gegenstands (120), der in einem Innenraum eines Kühlgeräts (110) angeordnet ist, wobei die Trainingsdaten mittels eines Verfahrens (200) eines der Ansprüche 1 bis 10 bereitgestellt sind.

13. Kühlgerät (110), umfassend eine Kamera (115) zur Erstellung eines Bilds eines Innenraums des Kühlgeräts (110); und eine Erkennungseinrichtung (125), die darauf trainiert ist, einen im Innenraum angeordneten Gegenstand (120) zu erkennen; wobei die Erkennungseinrichtung (125) auf der Basis von Trainingsdaten nach Anspruch 12 trainiert ist.
